Europäisches Patentamt

(19) European Patent Office

Office européen des brevets

(11) Numéro de publication : **0 155 046**
**B1**

# (12) FASCICULE DE BREVET EUROPÉEN

(45) Date de publication du fascicule du brevet :
13.12.89

(51) Int. Cl.⁴ : **H 03 M   1/74**

(21) Numéro de dépôt : 85200287.2

(22) Date de dépôt : 28.02.85

(54) **Dispositif convertisseur numérique-analogique.**

(30) Priorité : 02.03.84 FR 8403280

(43) Date de publication de la demande :
18.09.85 Bulletin 85/38

(45) Mention de la délivrance du brevet :
13.12.89 Bulletin 89/50

(84) Etats contractants désignés :
DE FR GB

(56) Documents cités :
FR—A— 2 427 013
US—A— 4 130 875
PROC. IEE, volume 118, no. 6, juin 1971, Londres, GB;
E.H. COOKE-YARBOROUGH: "Method of handling
widely ranging variables in digital data-storage and
transmission systems of limited wordlength", pages
761-764

(73) Titulaire : TELECOMMUNICATIONS RADIOELECTRI-
QUES ET TELEPHONIQUES T.R.T.
88, rue Brillat Savarin
F-75013 Paris (FR)
FR
N.V. Philips' Gloeilampenfabrieken
Groenewoudseweg 1
NL-5621 BA Eindhoven (NL)
DE GB

(72) Inventeur : Tomasi, Jean-Pierre
Société Civile S.P.I.D. 209 rue de L'Université
F-75007 Paris (FR)

(74) Mandataire : Chaffraix, Jean
Société Civile S.P.I.D. 209, rue de l'Université
F-75007 Paris (FR)

**Description**

La présente invention concerne un dispositif convertisseur numérique-analogique formé à partir d'un circuit convertisseur numérique-analogique du type fournissant à sa sortie une tension de sortie V(n') telle que :

$$V'(n') = k \cdot E \cdot \frac{n'}{M'} \qquad (1)$$

où k est une constante, E une tension appliquée à une entrée pour tension de référence, n' un nombre binaire appliqué à une entrée pour signaux binaires et M' la valeur maximum que peut atteindre n', dispositif comportant un réseau de rétro-réaction disposé entre la sortie du circuit convertisseur numérique-analogique et l'entrée pour tension de référence, amenant un taux de rétroaction égal à α.

Ce genre de dispositif trouve d'importantes applications en traitement de signal.

L'article : « Method of Handling Widely Ranging Variables in Digital Data-storage and Transmission Systems of Limited Wordlength » de E.H. COOK-YARBOROUGH et paru dans PROCEEDING OF IEE, volume 118, N° 6, juin 1971, décrit un tel dispositif.

Ainsi cet article enseigne qu'il est possible d'obtenir un convertisseur numérique-analogique procurant une bonne précision pour une tension de sortie de faible amplitude sans utiliser un nombre important d'éléments binaires.

Cependant le dispositif connu ne présente pas une réponse linéaire.

L'invention propose un dispositif du genre mentionné dans le préambule, qui présente une réponse linéaire.

. Pour cela, un tel dispositif est remarquable en ce qu'il comporte en outre des moyens de transcodage qui effectuent entre n' et n le nombre binaire appliqué à l'entrée, cette correspondance établissant une relation entre n et n' telle que n peut atteindre une valeur $M : M \geqslant 2M'$ selon une formule du type :

$$n' = \frac{n \cdot M'}{M\alpha + (1-\alpha)\,n}$$

et telle qu'il en résulte une relation « pseudo-linéaire » entre le nombre « n » et la tension V' :

$$V'(n_p) = K \cdot \frac{n_p}{M}$$

où K est une constante et $n_p$ des valeurs particulières de n.

Ce qu'on entend par relation « pseudo-linéaire » est une relation qui n'est linéaire que pour certaines valeurs $n_p$ de « n ». Cette notion sera explicitée plus profondément dans la suite du présent mémoire.

. Il est à noter qu'il est connu de la demande de brevet français N° 2 427 017 de disposer des moyens de transcodage aux entrées d'un circuit convertisseur numérique-analogique. Cependant aucune information n'est donnée en ce qui concerne la manière d'effectuer le transcodage pour résoudre le problème précité.

La description suivante, en regard des dessins annexés, le tout donné à titre d'exemple non limitatif fera bien comprendre comment l'invention peut être réalisée.

La figure 1 est un schéma d'un dispositif convertisseur numérique-analogique conforme à l'invention.

La figure 2 représente l'allure de la courbe en « marches d'escalier » représentant la tension V en fonction du nombre « n ».

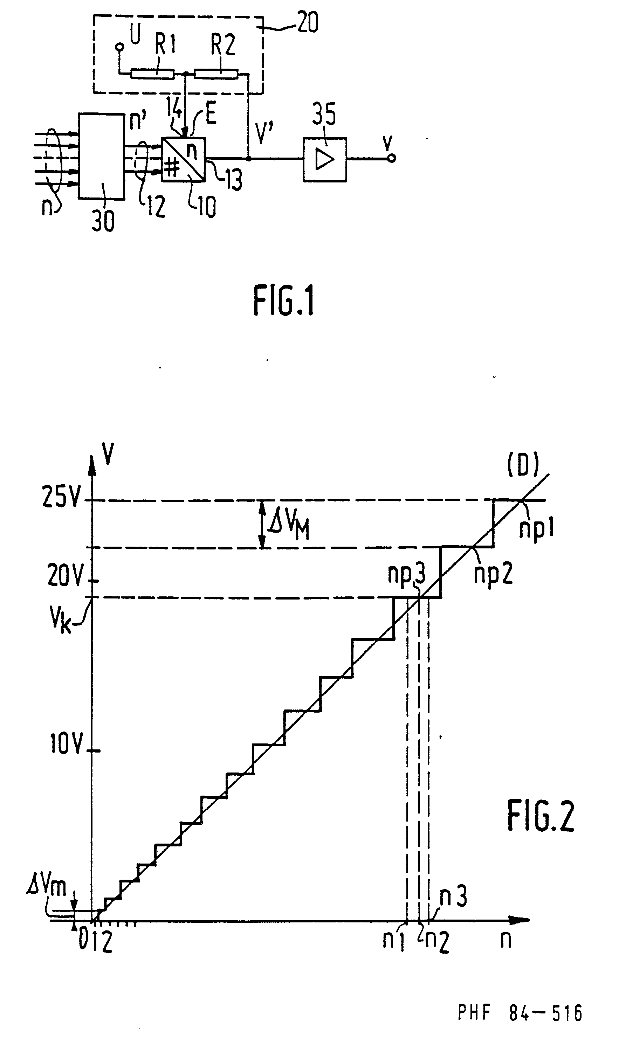

A la figure 1, on a représenté le dispositif convertisseur numérique-analogique de l'invention. Il est bâti autour d'un circuit convertisseur numérique-analogique 10, par exemple, le circuit intégré immatriculé NE5020 fabriqué par Signetics. A un nombre binaire n' appliqué à ses entrées pour signaux numériques 12 il fait correspondre une tension V' à sa sortie 13 :

$$V' = k \cdot E \cdot \frac{n'}{M'}$$

où k est une constante et E est la tension appliquée à son entrée pour signaux de référence 14, M' est la valeur maximale que peut prendre le nombre n'. M' est de la forme :

$$M' = 2^b - 1$$

où b est le nombre d'éléments binaires du nombre n'.

En guise d'exemple on suppose qu'un tel dispositif convertisseur est utilisé en radionavigation pour fournir une tension de commande à un indicateur d'altitude à partir d'une information numérique élaborée par un radioaltimètre. On se propose donc de fournir une tension entre 0 et 25 Volts pour des altitudes comprises entre 0 et 1 525 m avec une résolution meilleure que 0,15 m au voisinage de 0, c'est-à-dire que la tension doit à ce niveau évoluer par échelon de 2,5 mV. Selon les pratiques de l'art connu cela impose d'utiliser un convertisseur à 14 éléments binaires. L'invention permet avec un circuit convertisseur numérique-analogique traitant des nombres n′ de 10 éléments binaires (M′ = 1023) de fournir une tension précise à 2,5 mV près pour des valeurs basses de V.

Pour cela le dispositif convertisseur numérique-analogique comporte un réseau de contre-réaction (20) disposé entre la sortie où apparaît la tension V′ et l'entrée pour signaux de référence. Ce réseau (20) est formé d'un montage en série de deux résistances R1 et R2. A une première extrémité de ce montage est appliquée une tension U de 10 Volts et à la seconde extrémité la tension de sortie V. Le point commun de ces deux résistances R1 et R2 est relié à l'entrée 14. A cette entrée les constructeurs de circuit convertisseur numérique-analogique imposent que la valeur de la tension soit limitée de sorte que pour obtenir les 25 Volts requis, on utilise un amplificateur à courant continu 35 de gain égal à 2,5 ; la tension de sortie V de l'amplificateur 35 est donc V = 2,5 V′.

La tension E s'écrit alors :

$$E = U \frac{R_2}{R_1 + R_2} + V' \frac{R_1}{R_1 + R_2} \tag{3}$$

En posant

$$\alpha = \frac{R_2}{R_1 + R_2}$$

on obtient :

$$V' = \frac{\alpha \cdot U \cdot n' \cdot k}{M' - (1 - \alpha) \cdot n' \cdot k} \tag{4}$$

on suppose dans la suite pour la simplicité des explications que k = 1 ; avec α = 0,1 on se rend compte que V évolue pour n′ = 0, 1, 2 par pas de 2,4 mV. Il va de soi que cette précision n'est atteinte que pour les faibles valeurs de n′ ; pour n′ = 1020, 1021 les pas deviennent de l'ordre de 290 mV.

La formule (4) montre que la grandeur V n'est pas une fonction linéaire de la variable n′. Dans l'exemple d'utilisation le calcul de l'altitude est évidemment évalué au moyen du nombre n avec la précision la meilleure, ce qui fait que le nombre « n » est défini par 14 éléments binaires (M = 16 383). On a prévu un circuit de transcodage 30 qui permet d'obtenir une tension V proportionnelle au nombre « n » tout en ayant les précisions exigées aux basses amplitudes. Le circuit de transcodage peut être une mémoire morte faisant correspondre à tout code « n » un code « n′ » par la formule :

$$n' = \frac{n \cdot M'}{M\alpha + (1 - \alpha) n} \cdot \tag{5}$$

On prendra pour « n » la valeur entière la plus proche de la valeur donnée par (5). Pour les valeurs faibles de « n » à chaque n correspondra pratiquement une valeur de « n′ »; il n'en sera plus de même pour les valeurs fortes où pour plusieurs valeurs de « n » correspondra une seule valeur de « n′ ». C'est pour cela que l'on dit qu'il existe une relation pseudo-linéaire entre V ou V′ et la valeur « n ». On a représenté, bien schématiquement à la figure 2 l'allure de la courbe en marches d'escalier faisant correspondre V à la valeur n. On voit que les erreurs absolues sont inférieures, pour les faibles valeurs de n et V, aux erreurs absolues à fortes valeurs de V et n pour lesquelles les marches d'escalier sont plus importantes. Les paliers horizontaux sont plus larges par le fait que le circuit de transcodage donne la même valeur « n′ » pour plusieurs valeurs de « n ». Ainsi sur la figure 2 lorsque n = n1, n2, n3 on obtient la même valeur de tension $V_k$ alors que pour n = 0, 1, 2 on a différentes valeurs de V. Le réseau de contre-réaction 20 provoque des écarts entre les paliers qui varient de $\Delta V_m$ à $\Delta V_M$. Les valeurs particulières $n_{p1}$, $n_{p2}$... de la formule (2) sont prises à peu près sur le milieu des paliers de sorte qu'une droite D puisse passer par ces points et le point 0 d'origine. C'est cette droite D qui représente la fonction linéaire idéale entre « n » et « V ».

Il convient de noter que l'utilisation de réseaux de contre-réaction autres que celui décrit entre évidemment dans le cadre de l'invention.

## Revendications

1. Dispositif convertisseur numérique-analogique formé à partir d'un circuit convertisseur numérique-analogique du type fournissant à sa sortie une tension de sortie V′(n′) telle que :

$$V'(n') = k \cdot E \cdot \frac{n'}{M'}$$

où k est une constante, E une tension appliquée à une entrée pour tension de référence, n' un nombre binaire appliqué à une entrée pour signaux binaires et M' la valeur maximum que peut atteindre n', dispositif comportant un réseau de rétro-réaction disposé entre la sortie du circuit convertisseur numérique-analogique et l'entrée pour tension de référence, amenant un taux de rétroaction égal à α, dispositif caractérisé en ce qu'il comporte en outre des moyens de transcodage qui effectuent entre n' et n le nombre binaire appliqué à l'entrée, cette correspondance établissant une relation entre n et n' telle que n peut atteindre une valeur M : M ⩾ 2M' selon une formule du type :

$$n' = \frac{n \cdot M'}{M\alpha + (1 - \alpha)\,n}$$

et telle qu'il en résulte une relation « pseudo-linéaire » entre le nombre « n » et la tension V' :

$$V'(n_p) = K \cdot \frac{n_p}{M}$$

où K est une constante et $n_p$ des valeurs particulières de n.

2. Dispositif convertisseur numérique-analogique formé à partir d'un circuit convertisseur numérique-analogique selon la revendication 1, caractérisé en ce que le réseau de rétro-réaction est formé d'un montage en série de deux résistances R1 et R2 dont une extrémité (celle de R1) reçoit une tension fixe U et l'autre (celle de R2), la tension V' tandis que le point commun de ces deux résistances est relié à l'entrée pour tension de référence de sorte que le taux de réaction prend la valeur où :

$$\alpha = \frac{R_2}{R_1 + R_2}$$

3. Dispositif convertisseur numérique-analogique formé à partir d'un circuit convertisseur numérique-analogique selon l'une des revendications 1 à 2, caractérisé en ce que les moyens de transcodage sont formés par une mémoire morte.

4. Dispositif convertisseur numérique-analogique formé à partir d'un circuit convertisseur numérique-analogique selon l'une des revendications 1 à 3, caractérisé en ce qu'il est prévu en outre un amplificateur à courant continu de gain A de sorte que sa tension de sortie V est telle que V = AV'.

## Claims

1. A digital-to-analog converter arrangement formed on the basis of a digital-to-analog converter of a type producing at its output an output voltage V'(n') such that :

$$V'(n') = k \cdot E \cdot \frac{n'}{M'}$$

where k is a constant E is a voltage applied to a reference voltage input n' is a binary number applied to a binary signal input and M' is the maximum value n' can attain, the arrangement comprising a negative feedback network inserted between the output of the digital-to-analog converter circuit and the reference voltage input, leading to a negative feedback ratio which is equal to α, characterized in that it further includes transcoder means which realize a correspondence between the numbers n' and n, where n is the binary number applied to its input, this correspondence establishing a relationship between n and n' in a manner such that n may reach a value M : M ⩾ 2M' according to a formula of the type :

$$n' = \frac{n \cdot M'}{M\alpha + (1 - \alpha)\,n}$$

and such that this leads to a pseudo-linear relationship of :

$$V'(n_p) = K \cdot \frac{n_p}{M}$$

between the number n and the voltage V', where K is a constant and $n_p$ are specific values of n.

2. A digital-to-analog converter arrangement formed on the basis of a digital-to-analog converter circuit as claimed in Claim 1, characterized in that the negative feedback network is constituted by a series arrangement of two resistors $R_1$ and $R_2$ one end of which (the end of $R_1$) receives a fixed voltage U and the other end (the end of $R_2$) receives the voltage V' whilst the junction between these two resistors is connected to the reference voltage input, so that the feedback ratio assumes the value :

$$\alpha = \frac{R_2}{R_1 + R_2}$$

3. A digital-to-analog converter arrangement based on a digital-to-analog converter circuit as claimed in one of the Claims 1 and 2, characterized in that the transcoding means are constituted by a read-only memory.

4. A digital-to-analog converter arrangement based on a digital-to-analog converter circuit as claimed in one of the Claims 1 to 3, characterized in that a d.c. amplifier having a gain A is provided so that its output voltage is such that V = AV'.

**Patentansprüche**

1. Digital-Analog-Wandleranordnung auf Basis eines Digital-Analog-Wandlers vom Typ, der an dem Ausgang eine Ausgangsspannung V'(n') liefert, derart, dass :

$$V'(n') = k \cdot E \cdot \frac{n'}{M'}$$

wobei k eine Konstante ist, E eine einem Eingang für eine Bezugsspannung zugeführte Spannung ist, n' eine einem Eingang für binärse Signale zugeführte binäre Zahl ist und wobei M' der von n' maximal erreichbare Wert ist, wobei die Anordnung ein Gegenkopplungsnetzwerk zwischen dem Ausgang der Digital-Analog-Wandleranordnung und dem Eingang für die bezugsspannung aufweist, was zu einem Gegenkopplungsverhältnis gleich $\alpha$ führt, dadurch gekennzeichnet, dass sie ausserdem Transcodierungsmittel aufweist, die zwischen den Zahlen n' und n eine Übereinstimmung herbeiführen, wobei n die dem Eingang zugeführte binäre Zahl ist, wobei diese Übereinstimmung eine Beziehung zwischen n und n' darstellt, und zwar derart, dass n einen Wert $M : M \geqslant 2M'$ entsprechend der nachfolgenden Formel erreichen kann :

$$n' = \frac{n \cdot M'}{M\alpha + (1 - \alpha)\,n}$$

und dass dies zu einer pseudo-linearen Beziehung :

$$V'(n_p) = K \cdot \frac{n_p}{M}$$

zwischen der Zahl n und der Spannung V' fuhrt, wobei K eine Konstante ist und $n_p$ spezifische Werte von n sind.

2. Digital-Analog-Wandleranordnung auf Basis eines Digital-Analog-Wandlers nach Anspruch 1, dadurch gekennzeichnet, dass das Gegenkopplungsnetzwerk aus einer Reihenschaltung aus zwei Widerständen R1 und R2 besteht, deren eines Ende (das von R1) eine Festspannung U und deren anderes Ende (das von R2) die Spannung V' erhält, während der Verbindungspunkt dieser beiden Widerstände mit dem Bezugsspannungseingang verbunden ist, so dass das Rückkopplungsverhältnis den folgenden Wert annimmt :

$$\alpha = \frac{R_2}{R_1 + R_2}$$

3. Digital-Analog-Wandleranordnung auf Basis eines Digital-Analog-Wandlers nach einem der Ansprüche 1 und 2, dadurch gekennzeichnet, dass die Transcodierungsmittel aus einem Festwertspeicher gebildet sind.

4. Digital-Analog-Wandleranordnung auf Basis eines Digital-Analog-Wandlers nach einem der Ansprüche 1 bis 3, dadurch gekennzeichnet, dass ausserdem ein Gleichstromverstärker mit Verstärkung A derart vorgesehen ist, dass die Ausgangsspannung V derart ist dass V = AV' ist.

FIG.1

FIG.2